# EUROPEAN PATENT SPECIFICATION

(11) **EP 3 886 274 B1**
(45) Date of publication and mention of the grant of the patent: **12.06.2024**
(21) Application number: 19886228.6
(22) Date of filing: 05.11.2019
(51) Int. Cl.: H01S 5/42, H01S 5/183

(54) **LIGHT EMITTING DEVICE AND LIGHT EMITTING APPARATUS**
LICHTEMITTIERENDE VORRICHTUNG UND LICHTEMITTIERENDE EINRICHTUNG
DISPOSITIF ÉLECTROLUMINESCENT ET APPAREIL ÉLECTROLUMINESCENT

(30) Priority: 20.11.2018 JP 2018216958
(43) Date of publication of application: 29.09.2021
(73) Proprietor: Sony Semiconductor Solutions Corporation, Atsugi-shi, Kanagawa 243-0014 (JP)
(72) Inventor: ARAKIDA, Takahiro, Kumamoto 8691102 (JP)
(74) Representative: D Young & Co LLP
(86) International application number: PCT/JP2019/043223
(87) International publication number: WO 2020/105411

(56) References cited:
- EP-A2- 2 610 978
- WO-A1-03/003423
- WO-A2-2013/136205
- JP-A- 2003 142 775
- JP-A- 2012 023 107
- JP-A- 2017 168 715
- US-A- 6 023 485
- US-A1- 2009 052 490
- US-A1- 2011 019 709
- US-A1- 2013 092 850
- KING ROGER ET AL: "VCSEL Arrays for Fiber Optical Interconnects", ANNUAL REPORT, 1 January 1999 (1999-01-01), XP055875339, Retrieved from the Internet: URL:https://www.uni-ulm.de/fileadmin/websi te_uni_ulm/iui.inst.140/Jahresbericht/1999 /ar1999_rok.pdf>

## Description

### Technical Field

The present disclosure relates to a light emitting device and light emitting apparatus.

### Background Art

The development of surface emitting semiconductor lasers each having a plurality of light emitting regions is progressing (see, for example, PTL 1 and PTL 2). A surface emitting semiconductor laser is, for example, VCSEL (Vertical Cavity Surface Emitting LASER).

### Citation List

### Patent Literature

PTL 1: Japanese Unexamined Patent Application Publication No. 2017-147461
PTL 2: Japanese Unexamined Patent Application Publication No. 2017-216285

EP2610978 considers surface mount packaging for high-speed vertical cavity surface emitting lasers.

WO2013136205 relates to a VCSEL module and manufacturer thereof.

US2011/0019709 describes a semiconductor device and a method of manufacturing the

### Summary of the invention.

The invention is defined in the appending independent claim 1. Preferred embodiments are given in the dependent claims.

Incidentally, in a light-emitting device having a plurality of light emitting regions, it is desired that the plurality of light emitting regions have uniform light emission characteristics.

It is desirable to provide a light emitting device that makes it possible to obtain surface and a second surface that are opposed to each other. The semiconductor stacked body is provided on a first surface of the substrate. The semiconductor stacked body has a plurality of light emitting regions each of which allows a laser beam to be emitted. The first electrically conductive layer is provided on a front surface of the semiconductor stacked body. The front surface is opposite to the substrate. The second electrically conductive layer is provided on a second surface of the substrate. The second electrically conductive layer is provided to allow a predetermined voltage to the semiconductor stacked body in each of a plurality of the light emitting regions. The through wiring line is provided to electrically couple the first electrically conductive layer and the second electrically conductive layer.

A light emitting apparatus according to an embodiment of the present disclosure includes a light emitting device that is flip-chip mounted on a mounting substrate. The light emitting apparatus includes the light emitting device according to the embodiment of the present disclosure described above as the light emitting device.

In the light emitting device according to the embodiment of the present disclosure and the light emitting apparatus according to the embodiment, the second electrically conductive layer is provided on the second surface of the substrate and the second electrically conductive layer is coupled to the first electrically conductive layer via the through wiring line. The predetermined voltage is applied from the second electrically conductive layer to the semiconductor stacked body in each of a plurality of the light emitting regions.

### Brief Description of Drawing

[FIG. 1] FIG. 1 is a cross-sectional schematic diagram illustrating a configuration example of a semiconductor laser according to an embodiment of the present disclosure.
[FIG. 2] FIG. 2 is a plan view as viewed from a semiconductor stacked body side that illustrates a configuration example of the semiconductor laser illustrated in FIG. 1.
[FIG. 3] FIG. 3 is a plan view as viewed from a substrate side that illustrates a configuration example of the semiconductor laser illustrated in FIG. 1.
[FIG. 4] FIG. 4 is a schematic cross-sectional view of a configuration example of a light emitting apparatus in which the semiconductor laser illustrated in FIG. 1 is mounted on a mounting substrate.
[FIG. 5A] FIG. 5A is a cross-sectional schematic diagram describing a method of manufacturing the semiconductor laser illustrated in FIG. 1.
[FIG. 5B] FIG. 5B is a cross-sectional schematic diagram illustrating a step subsequent to FIG. 5A.
[FIG. 5C] FIG. 5C is a cross-sectional schematic diagram illustrating a step subsequent to FIG. 5B.
[FIG. 5D] FIG. 5D is a cross-sectional schematic diagram illustrating a step subsequent to FIG. 5C.
[FIG. 5E] FIG. 5E is a cross-sectional schematic diagram illustrating a step subsequent to FIG. 5D.
[FIG. 5F] FIG. 5F is a cross-sectional schematic diagram illustrating a step subsequent to FIG. 5E.
[FIG. 5G] FIG. 5G is a cross-sectional schematic diagram illustrating a step subsequent to FIG. 5F.
[FIG. 5H] FIG. 5H is a cross-sectional schematic diagram illustrating a step subsequent to FIG. 5G.

### Modes for Carrying Out the Invention

The following describes an embodiment of the present disclosure in detail with reference to the drawings. It is to be noted that description is given in the following order.

### 1. Embodiment (Example in which a second electrically conductive layer is provided on a back surface of a substrate)

### [Configuration Example]

### [Method of Manufacturing Semiconductor Laser]

### [Operation]

### [Workings]

### [Effects]

### <1. Embodiment>

### [Configuration Example]

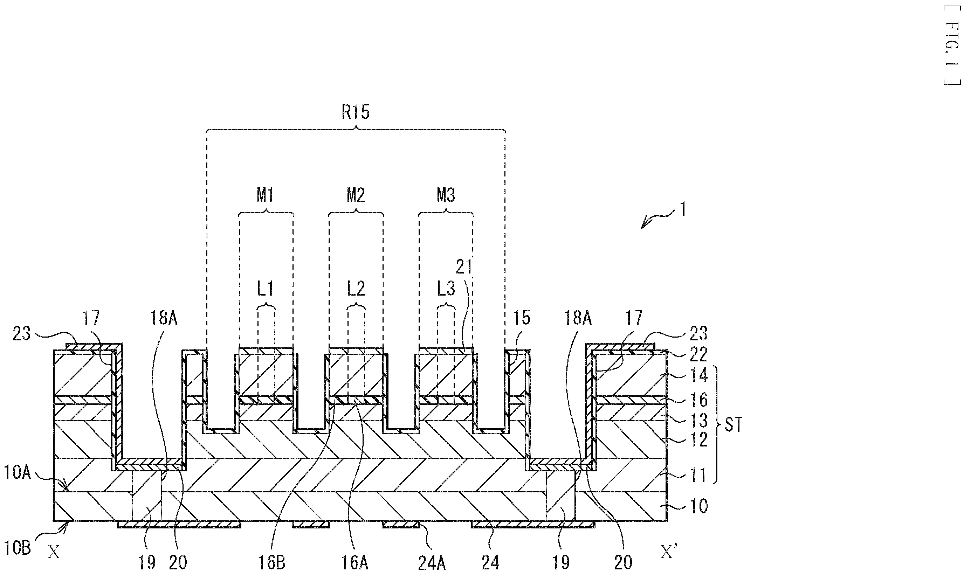

FIG. 1 illustrates a configuration example of a light emitting device (semiconductor laser 1) according to an embodiment of the present disclosure. The semiconductor laser 1 is a laser array in which a plurality of VCSELs is integrated. The semiconductor laser 1 has a semiconductor stacked body ST on a first surface 10A of a substrate 10. The substrate 10 is a specific example of a "substrate" of the present disclosure. The semiconductor stacked body ST is a specific example of a "semiconductor stacked body" of the present disclosure. The semiconductor stacked body ST has a buffer layer 11, a first light reflecting layer 12, an active layer 13, a current confining layer 16, and a second light reflecting layer 14 stacked in this order on the first surface 10A of the substrate 10. The semiconductor stacked body ST is provided with a first recess 15 in a first recess forming region R15, for example, by performing etching from the second light reflecting layer 14 to a portion of the first light reflecting layer 12. In the region of a portion of the formation region of the first recess 15, the semiconductor stacked body ST is left unetched. This provides a plurality (three in the diagram) of mesa regions M1, M2, and M3. Each of the mesa regions M1, M2, and M3 has, for example, a columnar shape such as a cylindrical shape. In each of the mesa regions M1, M2, and M3, a current confining region 16B is formed by the current confining layer 16 with a predetermined width from the outer periphery of the columnar shape. The inner portion of the current confining region 16B as viewed from the outer periphery side of the columnar shape is a current injection region 16A. The current injection regions 16A of the respective mesa regions M1, M2, and M3 correspond to light emitting regions L1, L2, and L3 of laser beams LT1, LT2, and LT3 (described below).

Two second recesses 17 are formed on both sides of the first recess forming region R15 of the semiconductor stacked body ST, for example, by performing etching from the second light reflecting layer 14 to a portion of the buffer layer 11. The region of a portion of the bottom surface of each of the second recesses 17 has a through opening 18A formed in the buffer layer 11 and the substrate 10. An insulating film 22 is formed on the front surface of the semiconductor stacked body ST other than the front surfaces of the semiconductor stacked body ST in the respective mesa regions M1, M2, and M3, the bottom surfaces of the second recesses 17, and the inner wall surfaces of the through openings 18A. A through wiring line 19 is formed inside each of the through openings 18A. A bottom surface electrically conductive layer 20 is formed on the bottom surface of each of the second recesses 17 to be coupled to the through wiring line 19. The through wiring line 19 corresponds to a specific example of a "through wiring line" of the present disclosure. An electrode pad 23 is formed from the bottom surface of the second recess 17 to the side wall surface of the second recess 17 and the front surface of the semiconductor stacked body ST to be coupled to the bottom surface electrically conductive layer 20. The electrode pad 23 is a specific example of a "first electrically conductive layer" of the present disclosure. An n electrode 24 is formed on a second surface 10B of the substrate 10. The n electrode 24 is a specific example of a "second electrically conductive layer" of the present disclosure. The n electrode 24 is provided to allow a predetermined voltage to be applied to the semiconductor stacked body ST in each of the light emitting regions L1, L2, and L3. The n electrode 24 is provided with an opening 24A in association with each of the light emitting regions L1, L2, and L3. It is possible to guide the laser beams LT1, LT2, and LT3 (described below) emitted from the light emitting regions L1, L2, and L3 to the outside from the openings 24A. A p electrode 21 is formed on the front surface of the semiconductor stacked body ST in each of the mesa regions M1, M2, and M3.

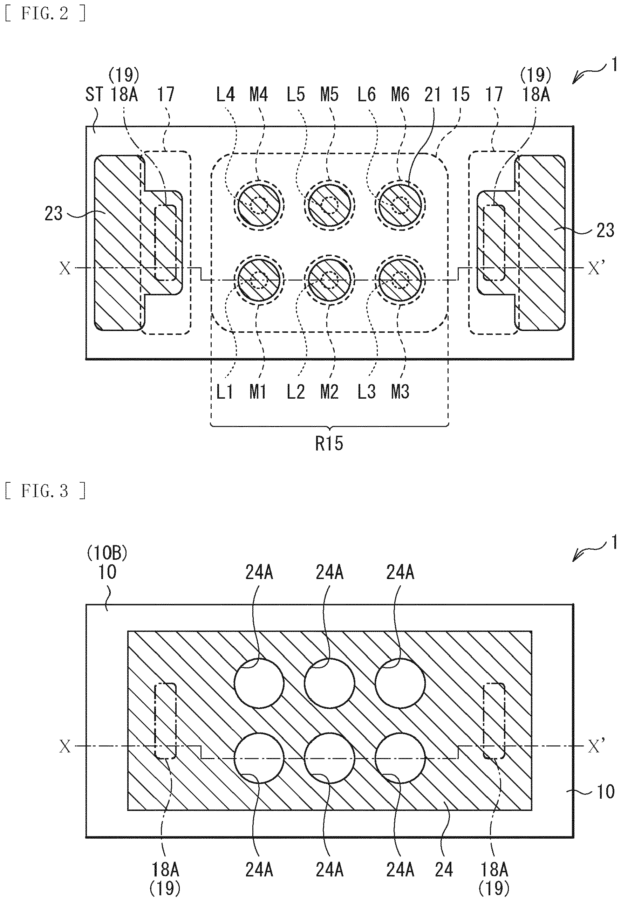

FIG. 2 illustrates a planar configuration as viewed from the semiconductor stacked body ST side of the semiconductor laser 1 illustrated in FIG. 1. FIG. 1 illustrates a cross-sectional configuration taken along an X-X' line illustrated in FIG. 2. FIG. 2 omits the insulating film 22. The semiconductor stacked body ST is provided with the first recesses 15 in the first recess forming region R15 to leave the plurality (six in the diagram) of mesa regions M1, M2, M3, M4, M5, and M6. FIG. 1 illustrates a cross section that crosses the three mesa regions M1, M2, and M3 of the six mesa regions M1, M2, M3, M4, M5, and M6. As illustrated in FIG. 2, the p electrode 21 is formed on the front surface of the semiconductor stacked body ST in each of the mesa regions M1, M2, M3, M4, M5, and M6. In the semiconductor stacked body ST, the plurality (two in the diagram) of second recesses 17 is formed on both sides of the first recess forming region R15 and the through opening 18A is formed in the region of a portion of the bottom surface of each of the second recesses 17. The through wiring line 19 is formed inside each of the through openings 18A. The electrode pad 23 is formed from the bottom surface of the second recess 17 to the side wall surface of the second recess 17 and the front surface of the semiconductor stacked body ST.

FIG. 3 illustrates a planar configuration as viewed from the substrate 10 side of the semiconductor laser 1 illustrated in FIG. 1. FIG. 1 illustrates a cross-sectional configuration taken along an X-X' line illustrated in FIG. 3. The n electrode 24 is formed on the second surface 10B of the substrate 10. The n electrode 24 is provided with the respective openings 24A in association with the light emitting regions L1, L2, L3, L4, L5, and L6.

In the semiconductor laser 1 illustrated in each of FIGs. 1 to 3, each of the six light emitting regions L1, L2, L3, L4, L5, and L6 is VCSEL. In other words, the semiconductor laser 1 is a laser array in which six VCSELs are integrated. Each of FIGs. 1 to 3 illustrates a configuration in which six VCSELs are integrated, but there is no limitation on the number of VCSELs that are integrated. For example, it is possible to adopt a configuration in which several tens of VCSELs to several thousands of VCSELs are integrated.

The substrate 10 includes, for example, a gallium arsenide (GaAs) substrate. The substrate 10 sometimes includes indium phosphorus (InP), gallium nitride (GaN), silicon (Si), silicon carbide (SiC), or the like through a bonding process or the like of the material system of the light emitting device and a heterogeneous substrate.

The buffer layer 11 includes, for example, GaAs or the like. The buffer layer 11 is provided as a contact layer that electrically couples the substrate 10 and the first light reflecting layer 12.

The first light reflecting layer 12 is a DBR (Distributed Bragg Reflector) layer disposed between the buffer layer 11 and the active layer 13. The first light reflecting layer 12 is opposed to the second light reflecting layer 14 with the active layer 13 and the current confining layer 16 interposed in between. The first light reflecting layer 12 is configured to resonate the light generated in the active layer 13 between the first light reflecting layer 12 and the second light reflecting layer 14.

The first light reflecting layer 12 has a stacked structure in which low refractive index layers and high refractive index layers are alternately stacked on each other. A low refractive index layer is n-type Al_{X1}Ga_{(1-X1)}As (0 < X1 < 1) having an optical film thickness of λ/4. λ represents the oscillating wavelength of the laser beam emitted from each of the light emitting regions L1, L2, L3, L4, L5, and L6. A high refractive index layer is n-type Al_{X2}Ga_{(1-X2)}As (0 < X2 < 1) having an optical film thickness of λ/4.

The active layer 13 is provided between the first light reflecting layer 12 and the second light reflecting layer 14. The active layer 13 includes, for example, an aluminum-gallium-arsenide (AlGaAs) based semiconductor material. This active layer 13 receives a hole (hole) injected from the p electrode 21 via the current injection region 16A and generates induced emission light. For example, undoped Al_{X3}Ga_{(1-X3)}As (0 < X3 < 1) is usable for the active layer 13. The active layer 13 may have a multi quantum well (MQW: Multi Quantum Well) structure of GaAs and AlGaAs, for example. The active layer 13 may have a multi quantum well structure of indium gallium arsenide (InGaAs) and AlGaAs.

The current confining region 16B is formed to have an annular shape with a predetermined width in the current confining layer 16 from the outer periphery side of the columnar shape of each of the mesa regions M1, M2, M3, M4, M5, and M6 to the inner side. The inner portion of the current confining region 16B as viewed from the outer periphery side of the columnar shape is the current injection region 16A. It is possible to form the current confining region 16B, for example, by performing an oxidization process on the current confining layer 16 from the outer periphery side of the columnar shape of each of the mesa regions M1, M2, M3, M4, M5, and M6. The current confining layer 16 is formed by using, for example, p-type Al_{X4}Ga_{(1-X4)}As (0.9 < X4 < 1). The current confining region 16B is formed by oxidizing the current confining layer 16 and includes, for example, aluminum oxide (AlOx). The current injection region 16A is a portion that has not been oxidized inside the current confining region 16B. The provision of a current confining structure confines electric currents injected into the active layer 13 from the p electrode 21 and increases the current injection efficiency. The radius of a substantially circular current injection region 16A is, for example, 1 µm to 20 µm.

The second light reflecting layer 14 is a DBR layer disposed between the current confining layer 16 and the insulating film 22. The second light reflecting layer 14 is opposed to the first light reflecting layer 12 with the current confining layer 16 and the active layer 13 interposed in between.

The second light reflecting layer 14 has a stacked structure in which low refractive index layers and high refractive index layers are alternately stacked on each other. A low refractive index layer is n-type Al_{X5}Ga_{(1-X5)}As (0 < XS < 1) having an optical film thickness of X/4. A high refractive index layer is n-type Al_{X6}Ga_{(1-X6)}As (0 < X6 < 1) having an optical film thickness of λ/4.

The insulating film 22 is formed by using, for example, an insulator such as silicon nitride (SiN) or silicon oxide (SiO₂).

The through wiring line 19 is formed by using, for example, a metal such as gold (Au), copper (Cu), or nickel (Ni). The bottom surface electrically conductive layer 20 is formed by using, for example, a multilayered film of metals such as gold germanium (AuGe)/nickel/gold. The electrode pad 23 is formed by using, for example, a multilayered film of metals such as titanium (Ti)/gold.

The p electrode 21 is formed by using, for example, a single layer film or a multilayered film of metals such as gold, germanium (Ge), silver (Ag), palladium (Pd), platinum (Pt), nickel, titanium, vanadium (V), tungsten (W), chromium (Cr), aluminum (Al), copper, zinc (Zn), tin (Sn), and indium (In). For example, a multilayered film of titanium/platinum/gold is used.

The n electrode 24 is formed by using, for example, a single layer film or a multilayered film of metals similar to those of the p electrode 21. Alternatively, the n electrode 24 may be formed by using a transparent electrode such as ITO (Indium-Tin-Oxide or tin-doped indium oxide), zinc oxide, tin oxide, and titanium oxide. It is possible to include a material and form a pattern for the n electrode 24 in consideration of even thermal conductivity. It is possible to increase the heat dissipation of the substrate 10.

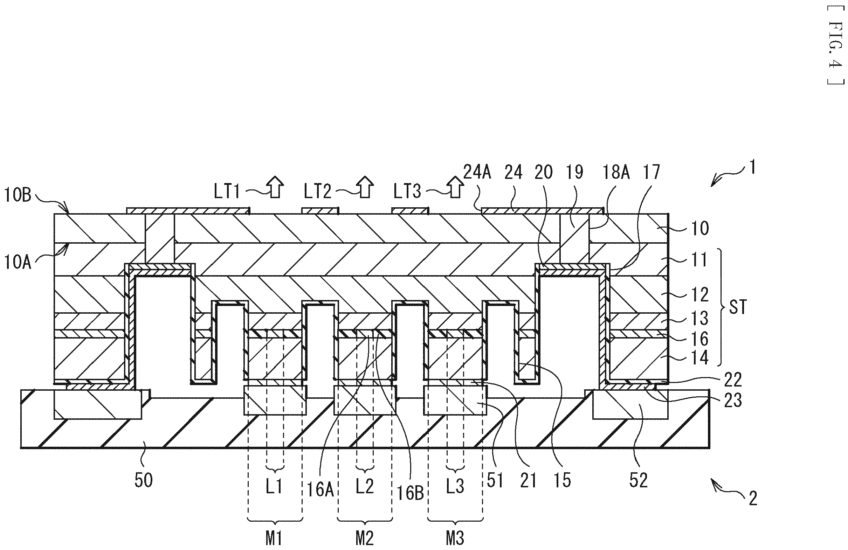

FIG. 4 illustrates a configuration example of a light emitting apparatus in which the semiconductor laser illustrated in FIG. 1 is mounted on a mounting substrate. A light emitting apparatus 3 has a configuration in which the semiconductor laser 1 illustrated in FIG. 1 is flip-chip mounted on a mounting substrate 2. The flip-chip mounting is mounting the semiconductor laser 1 with the formation surface of the electrode pad 23 and the p electrode 21 facing the mounting substrate 2. The mounting substrate 2 includes, for example, a first electrode 51 and a second electrode 52 on a substrate 50. The first electrode 51 is provided to the p electrode 21 of the semiconductor laser 1 and the second electrode 52 is provided to the electrode pad 23 of the semiconductor laser 1 in the respective corresponding patterns. It is possible to couple the first electrode 51 and the p electrode 21 and couple the second electrode 52 and the electrode pad 23, for example, by solder coupling or using an anisotropic electrically conductive adhesive, an anisotropic electrically conductive sheet, or the like. The mounting substrate 2 may be provided with a drive circuit such as a power supply circuit for the semiconductor laser 1. In that case, a terminal of the drive circuit in itself may be configured to be coupled to the p electrode 21 and the electrode pad 23 of the semiconductor laser 1.

In a case where predetermined voltages are applied to the p electrode 21 and the electrode pad 23 in the semiconductor laser 1, voltages are applied to the semiconductor stacked body ST in each of the mesa regions M1, M2, and M3 from the p electrode 21 and the n electrode 24 because the electrode pad 23 is coupled to the n electrode 24 via the bottom surface electrically conductive layer 20 and the through wiring line 19. This injects an electron from the n electrode 24 and injects a hole from the p electrode 21 in each of the light emitting regions L1, L2, and L3. Light generated by recombining an electron and a hole is resonated and amplified between a pair of DBR layers (the first light reflecting layer 12 and the second light reflecting layer 14) and the laser beams LT1, LT2, and LT3 are emitted from the substrate 10 side through the openings 24A. Although omitted in FIG. 4, the same applies to the mesa regions M4, M5, and M6.

In a case where the n electrode 24 is not provided, but an attempt is made to apply a voltage to each of the light emitting regions L1, L2, and L3 through the substrate 10, the electrical resistance of the substrate 10 (the voltage drop in a case where the current flows through the substrate 10) sometimes varies the voltages that are applied to the respective light emitting regions L1, L2, and L3. The same applies even in the presence of the light emitting regions L1, L2, and L3 that are different in distance from the n electrode 24. The electrical resistance of the substrate 10 (the voltage drop in a case where the current flows through the substrate 10) sometimes varies the voltages that are applied to the respective light emitting regions L1, L2, and L3. In the semiconductor laser 1, the n electrode 24 is provided to allow a predetermined voltage to be applied to each of the light emitting regions L1, L2, and L3. This makes it possible to uniformly apply voltages from the n electrode 24 to the respective light emitting regions L1, L2, and L3 in the semiconductor laser 1 regardless of the position of each of the light emitting regions L1, L2, and L3.

In the semiconductor laser 1 included in the light emitting apparatus 3, the p electrode 21 is individually provided in each of the light emitting regions L1, L2, and L3. The p electrode 21 is individually coupled to the first electrode 51 of the mounting substrate 2. This makes it possible to selectively apply voltages from the p electrode 21 to the light emitting regions L1, L2, and L3 for each of the light emitting regions L1, L2, and L3. In other words, it is possible to performs driving to individually emit the laser beams LT1, LT2, and LT3 from the selected light emitting regions L1, L2, and L3 of the plurality of light emitting regions L1, L2, and L3.

The configuration has been described in which the laser beams LT1, LT2, and LT3 are emitted through the openings 24A in the semiconductor laser 1, but the present technology is not limited thereto. For example, in a case where the n electrode 24 is formed by using, a transparent electrode such as ITO and has transparency to the laser beams LT1, LT2, and LT3, the laser beams LT1, LT2, and LT3 are not blocked by the n electrode 24. This eliminates the necessity to provide the openings 24A. In addition, the emission directions of the laser beams LT1, LT2, and LT3 do not have to be the substrate 10 side. In a case where the laser beams LT1, LT2, and LT3 are emitted from the semiconductor stacked body ST side, members such as a wiring line and an electrode each having a light-shielding property are disposed at positions at which the members do not prevent the laser beams LT1, LT2, and LT3 from being emitted.

The semiconductor laser 1 has a configuration in which the number of electrode pads 23 is smaller than the number of p electrodes 21. The p electrode 21 is provided in each of the light emitting regions L1, L2, and L3 as described above and the number of p electrodes 21 thus corresponds to the number of light emitting regions L1, L2, and L3. The electrode pad 23 is provided to be coupled to the n electrode 24 that is an electrode common to the plurality of light emitting regions L1, L2, and L3. The two electrode pads 23 are provided in the semiconductor laser 1. It is sufficient if the number of electrode pads 23 is at least one and it is possible to include a smaller number of electrode pads 23 than the number of p electrodes 21. A smaller number of electrode pads 23 are preferable because a smaller number of electrode pads 23 simplify the configuration of the semiconductor laser 1 more and facilitate the manufacturing.

### [Method of Manufacturing Semiconductor Laser]

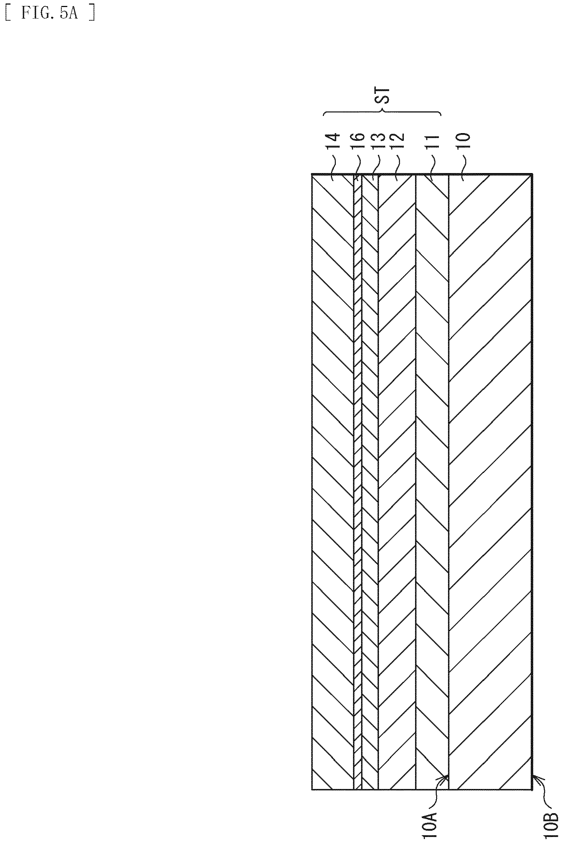

Next, a method of manufacturing the semiconductor laser 1 is described with reference to FIGs. 5A to 5H. Each of FIGs. 5A to 5H illustrates a step in the method of manufacturing the semiconductor laser 1.

First, as illustrated in FIG. 5A, the buffer layer 11, the first light reflecting layer 12, the active layer 13, the current confining layer 16, and the second light reflecting layer 14 are stacked in this order on the substrate 10 to form the semiconductor stacked body ST. The semiconductor stacked body ST is formed through epitaxial crystal growth using, for example, a molecular beam epitaxy (MBE: Molecular Beam Epitaxy) method, a metal organic chemical vapor deposition (MOCVD: Metal Organic Chemical Vapor Deposition) method, or the like.

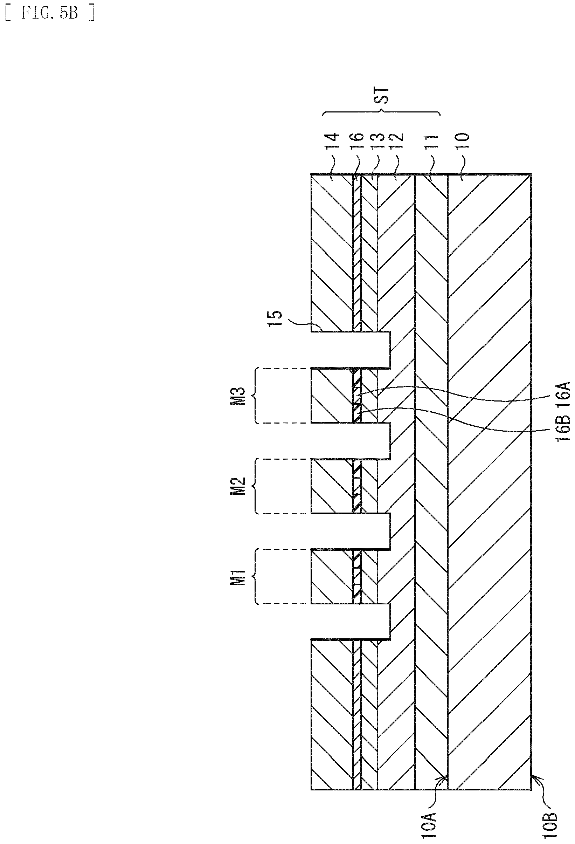

Next, as illustrated in FIG. 5B, a resist film (not illustrated) having a predetermined pattern is patterned and formed in an upper layer of the semiconductor stacked body ST in a photolithography step. Etching is performed from the second light reflecting layer 14 to a portion of the first light reflecting layer 12 for removal to form the first recess 15. The etching is performed, for example, by reactive ion etching (RIE: Reactive Ion Etching). Here, the resist film described above is formed to have a pattern for protecting the mesa regions M1, M2, and M3. This leaves the semiconductor stacked body ST having a columnar shape in the mesa regions M1, M2, and M3 in the etching process described above. Subsequently, the resist film is removed. Next, high-temperature treatment is performed in a water-vapor atmosphere to oxidize the current confining layer 16 from the outer periphery of the columnar shape in each of the mesa regions M1, M2, and M3 with a predetermined width, thereby forming the current confining region 16B. The region inside the current confining region 16B is the current injection region 16A.

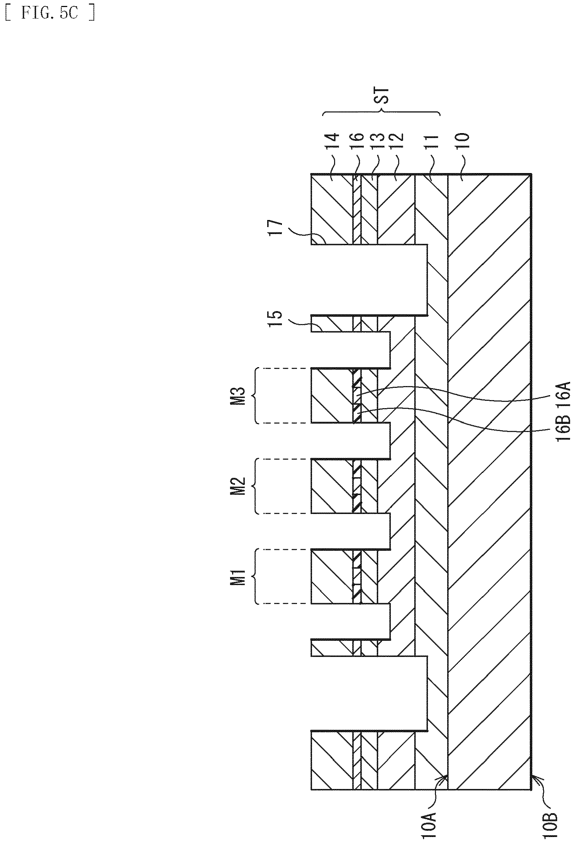

Subsequently, as illustrated in FIG. 5C, a resist film (not illustrated) having a predetermined pattern is patterned and formed in an upper layer of the semiconductor stacked body ST to form the second recess 17 by performing etching such as RIE from the second light reflecting layer 14 to a portion of the buffer layer 11 for removal. Next, the resist film is removed.

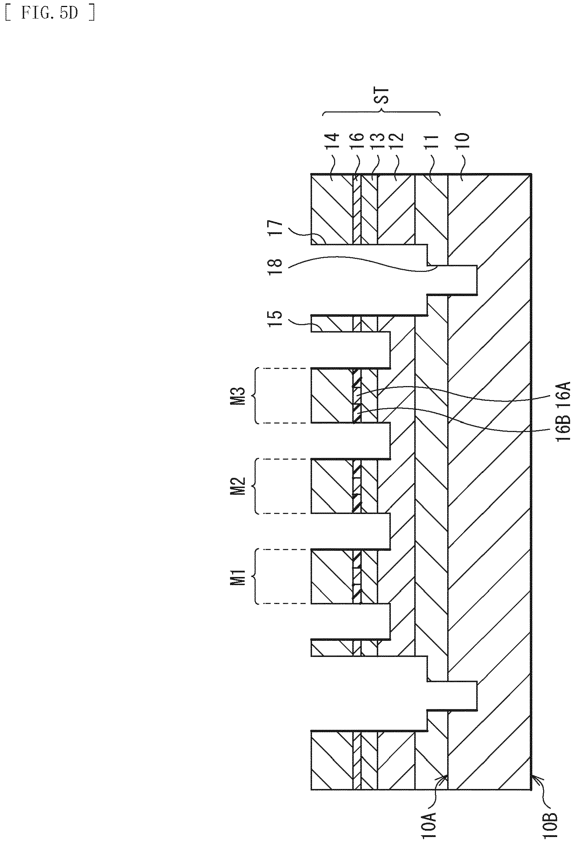

Subsequently, as illustrated in FIG. 5D, a resist film (not illustrated) having a predetermined pattern is patterned and formed in an upper layer of the semiconductor stacked body ST to form the through wiring line recess 18 by performing etching such as RIE up to a portion of the substrate 10 on a portion of the bottom of the second recess 17 for removal. Next, the resist film is removed.

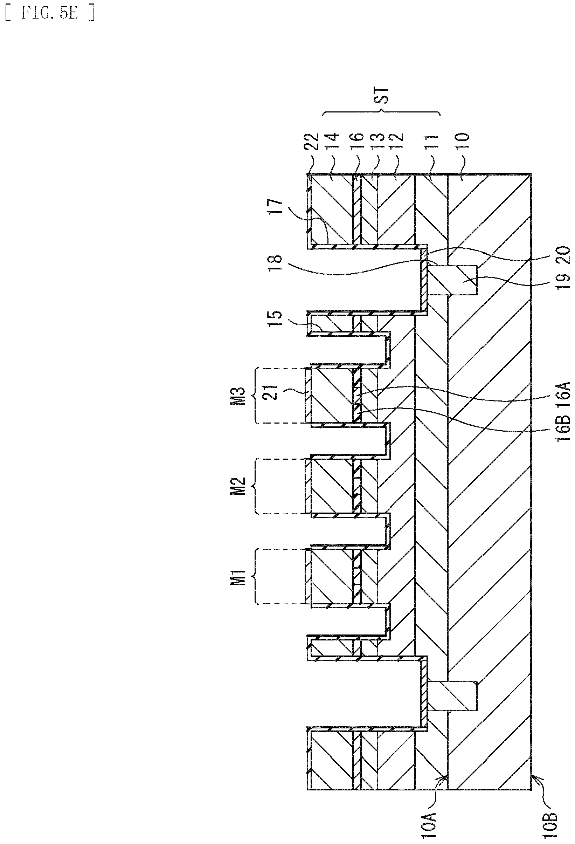

Subsequently, as illustrated in FIG. 5E, the insulating film 22 of silicon nitride or the like is formed, for example, in a chemical vapor deposition (CVD: Chemical Vapor Deposition) method or an atomic layer deposition (ALD: Atomic Layer Deposition) method. The insulating film 22 is formed to cover the inner wall surface of the first recess 15 and the inner wall surface of the second recess 17. Next, a resist film (not illustrated) having a predetermined pattern is patterned and formed in an upper layer of the semiconductor stacked body ST and etching such as RIE is performed to remove the insulating film 22 on the front surface of the semiconductor stacked body ST in each of the mesa regions M1, M2, and M3, the bottom surface of the second recess 17, and the inner wall surface of a through wiring line recess 18 of the front surface of the semiconductor stacked body ST. Next, gold or the like is embedded inside the through wiring line recess 18 , for example, by an electroplating process or the like to form the through wiring line 19. Subsequently, the bottom surface electrically conductive layer 20 is formed by forming a multilayered film of the metals of AuGe/Ni/Au at the bottom of the second recess 17, for example, in a metal deposition method or the like. Next, the p electrode 21 is formed by forming a multilayered film of the metals of Ti/Pt/Au on the front surface of the semiconductor stacked body ST in each of the mesa regions M1, M2, and M3, for example, in a sputtering method or the like.

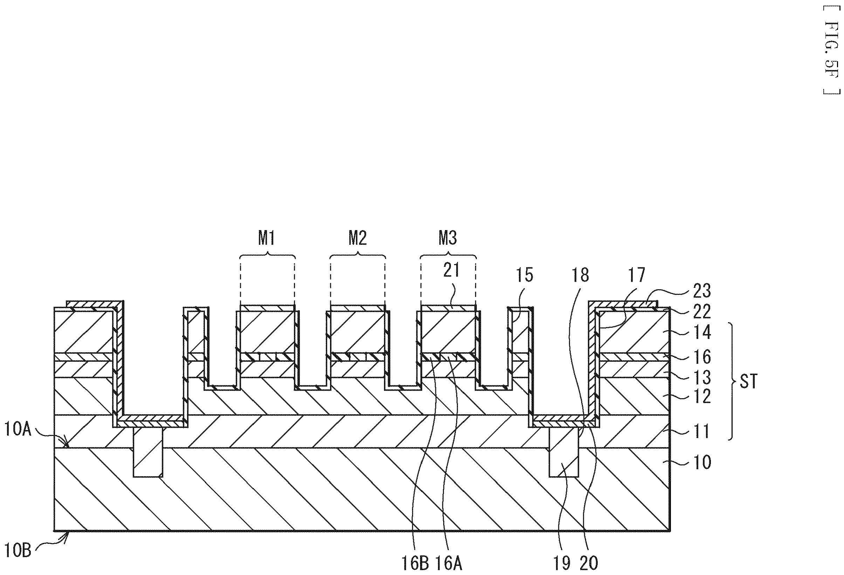

Subsequently, as illustrated in FIG. 5F, the electrode pad 23 is formed to be coupled to the bottom surface electrically conductive layer 20 by forming a multilayered film of the metals of Ti/Au from the bottom surface of the second recess 17 to the side wall surface of the second recess 17 and the front surface of the semiconductor stacked body ST, for example, in a sputtering method or the like.

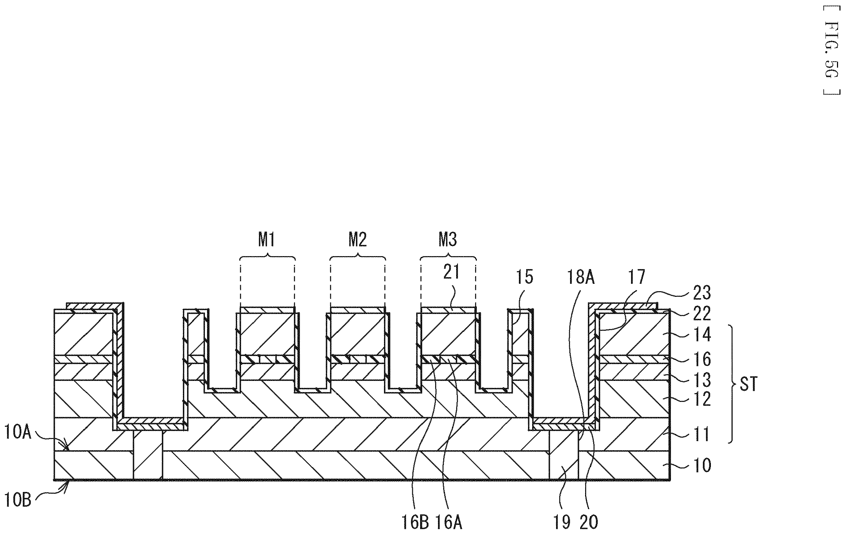

Next, as illustrated in FIG. 5G, the second surface 10B of the substrate 10 is polished, for example, by a chemical mechanical polishing (Chemical Mechanical Polishing) process until the through wiring line 19 is exposed.

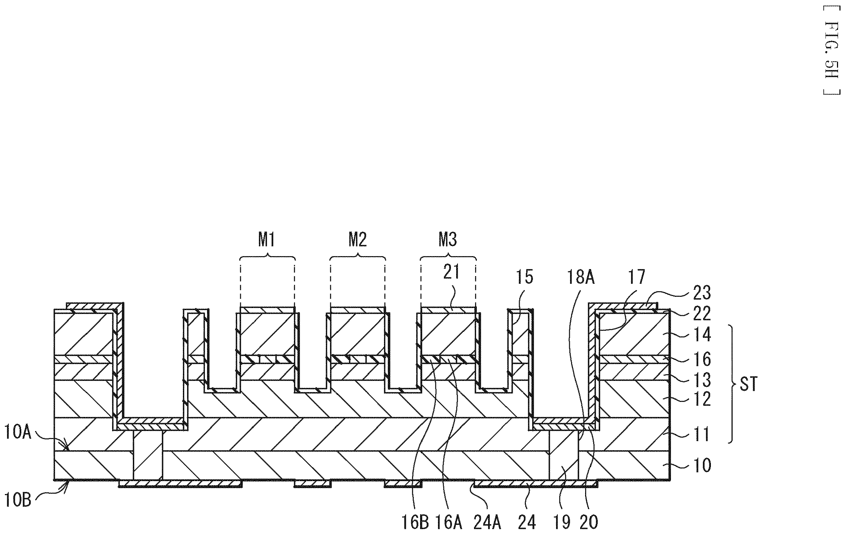

Subsequently, as illustrated in FIG. 5H, the n electrode 24 is formed by forming a multilayered film of the metals of AuGe/Ni/Au on the second surface 10B of the substrate 10, for example, in a metal deposition method or the like. The n electrode 24 is provided with the openings 24A corresponding to the light emitting regions L1, L2, and L3 in the respective mesa regions M1, M2, and M3 to complete the semiconductor laser 1.

### [Operation]

Subsequently, the operation of the semiconductor laser 1 according to the present embodiment is described with reference to FIG. 1. In a case where predetermined voltages are applied to the p electrode 21 and the electrode pad 23 in the semiconductor laser 1, voltages are applied to the semiconductor stacked body ST in each of the mesa regions M1, M2, and M3 from the p electrode 21 and the n electrode 24. This injects an electron from the n electrode 24 and injects a hole from the p electrode 21 in each of the light emitting regions L1, L2, and L3. The recombination of the electron and the hole generates light. The light is resonated and amplified between a pair of DBR layers and the laser beams LT1, LT2, and LT3 are emitted from the substrate 10 side through the openings 24A.

### [Workings]

In the semiconductor laser 1 according to the present embodiment, the n electrode 24 is provided to allow a predetermined voltage to be applied to the second surface of the substrate 10 in each of the light emitting regions L1, L2, and L3. The electrode pad 23 is coupled to the n electrode 24 via the through wiring line 19. It is possible to apply a voltage to the n electrode 24 from the electrode pad 23 provided on the second surface 10B of the substrate 10.

### [Effects]

As described above, in the semiconductor laser 1 according to the present embodiment, the n electrode 24 is provided to allow a predetermined voltage to be applied to the second surface of the substrate 10 in each of the light emitting regions L1, L2, and L3. The application of a voltage to the n electrode 24 makes it possible to uniformly apply voltages to the light emitting regions L1, L2, and L3 regardless of the position of each of the light emitting regions L1, L2, and L3.

The semiconductor laser 1 is provided with the p electrode 21 and the electrode pad 23 on the same surface (second surface 10B) as that of the substrate 10 and it is thus possible to flip-chip mount the semiconductor laser 1.

The semiconductor laser 1 is individually provided with the p electrode 21 for each of the light emitting regions L1, L2, and L3. This makes it possible to perform driving to individually emit the laser beams LT1, LT2, and LT3 from the selected light emitting regions L1, L2, and L3 of the light emitting regions L1, L2, and L3.

It is possible for the semiconductor laser 1 to include a material and form a pattern for the n electrode 24 in consideration of even thermal conductivity. It is possible to increase the heat dissipation of the substrate 10.

As described above, it is possible to make light emission characteristics for laser beams between the light emitting regions L1, L2, and L3.

Although the above has given description with reference to the embodiment, the present technology is not limited to the embodiment described above. The present technology may be modified in a variety of ways.

The semiconductor laser including six VCSELs has been described in the embodiment described above, but this is not limitative. It is also possible to apply this, for example, to a semiconductor laser in which several tens of VCSELs to several thousands of VCSELs are integrated instead. The distance between the light emitting region of each laser and the n electrode sometimes varies more as a larger number of lasers are integrated. The present technology, however, makes it possible to apply a voltage to the light emitting region of each laser with a voltage difference suppressed to be small.

The present technology is applicable to a variety of electronic apparatuses including a semiconductor laser. For example, the present technology is applicable to a light source included in a portable electronic apparatus such as a smartphone, a light source of each of a variety of sensing apparatuses that each sense a shape, an operation, and the like, or the like.

It is to be noted that the effects described herein are merely illustrative and non-limiting. In addition, other effects may be provided.

It is to be noted that the present technology may be configured as below. The present technology having the following configurations makes it possible to uniformly apply voltages to a semiconductor stacked body in a plurality of light emitting regions. This makes it possible to obtain uniform light emission characteristics between the plurality of light emitting regions.

The present application claims the priority on the basis of Japanese Patent Application No. 2018-216958 filed on November 20, 2018 with Japan Patent Office.

It should be understood by those skilled in the art that various modifications, combinations, sub-combinations, and alterations may occur depending on design requirements and other factors insofar as they are within the scope of the appended claims

## Claims

1. A light emitting device (1) comprising:
a substrate (10) having a first surface (10A) and a second surface that are opposed to each other;
a semiconductor stacked body (ST) that is provided on the first surface of the substrate, the semiconductor stacked body having a plurality of light emitting regions (L1, L2, L3) each of which allows a laser beam to be emitted;
a first electrically conductive layer (23) that is provided on a front surface of the semiconductor stacked body, the front surface being opposite to the substrate;
a second electrically conductive layer (24) that is provided on the second surface of the substrate, the second electrically conductive layer being provided to allow a predetermined voltage to be applied to the semiconductor stacked body in each of a plurality of the light emitting regions;
a through wiring line (19) that electrically couples the first electrically conductive layer and the second electrically conductive layer; and
a plurality of electrodes (21) that is provided on the front surface of the semiconductor stacked body, the front surface being opposite to the substrate, the plurality of electrodes being provided to allow predetermined voltages to be applied to the semiconductor stacked body in a plurality of the respective light emitting regions.

2. The light emitting device according to claim 1, wherein the semiconductor stacked body has a first light reflecting layer (12), an active layer (13), and a second light reflecting layer (14) stacked in order from the substrate side.

3. The light emitting device according to claim 2, wherein the semiconductor stacked body further includes a current confining layer (16) between the active layer and the second light reflecting layer, the current confining layer having a current injection region (16A).

4. The light emitting device according to any one of claims 1-3, wherein the semiconductor stacked body has a plurality of mesa regions (M1, M2, M3) each including a plurality of the light emitting regions.

5. The light emitting device according to claim 1, wherein there are a plurality of first electrically conductive layers including the first electrically conductive layer; and a number of the plurality of first electrically conductive layers is smaller than a number of the electrodes.

6. The light emitting device according to any one of claims 1-5, wherein each of a plurality of the light emitting regions emits the laser beam from the substrate side.

7. The light emitting device according to claim 6, wherein the second electrically conductive layer has a plurality of openings that is provided in association with a plurality of the light emitting regions, the plurality of openings each guiding the laser beam.

8. The light emitting device according to claim 6, wherein the second electrically conductive layer includes an electrically conductive layer that has transparency to the laser beam.

9. The light emitting device according to any one of claims 1-8, wherein the light emitting device is flip-chip mounted on a mounting substrate from a side on which the first electrically conductive layer is provided.

10. A light emitting apparatus comprising
a light emitting device according to claim 1 that is flip-chip mounted on a mounting substrate.

## Patentansprüche

1. Lichtemittierende Vorrichtung (1), umfassend:
ein Substrat (10), das eine erste Oberfläche (10A) und eine zweite Oberfläche aufweist, die einander entgegengesetzt sind;
einen gestapelten Halbleiterkörper (ST), der auf der ersten Oberfläche des Substrats bereitgestellt ist, wobei der gestapelte Halbleiterkörper eine Vielzahl von lichtemittierenden Bereichen (L1, L2, L3) aufweist, von denen jeder ermöglicht, dass ein Laserstrahl emittiert wird;
eine erste elektrisch leitfähige Schicht (23), die auf einer vorderen Oberfläche des gestapelten Halbleiterkörpers bereitgestellt ist, wobei die vordere Oberfläche dem Substrat gegenüberliegt;
eine zweite elektrisch leitfähige Schicht (24), die auf der zweiten Oberfläche des Substrats bereitgestellt ist, wobei die zweite elektrisch leitfähige Schicht bereitgestellt ist, um zu ermöglichen, dass eine vorbestimmte Spannung an den gestapelten Halbleiterkörper in jedem einer Vielzahl von lichtemittierenden Bereichen angelegt wird;
eine Durchverdrahtungsleitung (19), die die erste elektrisch leitfähige Schicht und die zweite elektrisch leitfähige Schicht elektrisch koppelt; und
eine Vielzahl von Elektroden (21), die auf der vorderen Oberfläche des gestapelten Halbleiterkörpers bereitgestellt ist, wobei die vordere Oberfläche dem Substrat gegenüberliegt, wobei die Vielzahl von Elektroden bereitgestellt ist, um zu ermöglichen, dass vorbestimmte Spannungen an den gestapelten Halbleiterkörper in einer Vielzahl der jeweiligen lichtemittierenden Bereiche angelegt werden.

2. Lichtemittierende Vorrichtung nach Anspruch 1, wobei der gestapelte Halbleiterkörper eine erste lichtreflektierende Schicht (12), eine aktive Schicht (13) und eine zweite lichtreflektierende Schicht (14), die in einer Reihenfolge von der Substratseite gestapelt ist, aufweist.

3. Lichtemittierende Vorrichtung nach Anspruch 2, wobei der gestapelte Halbleiterkörper ferner eine Strombegrenzungsschicht (16) zwischen der aktiven Schicht und der zweiten lichtreflektierenden Schicht einschließt, wobei die Strombegrenzungsschicht einen Stromeinspeisungsbereich (16A) aufweist.

4. Lichtemittierende Vorrichtung nach einem der Ansprüche 1 bis 3, wobei der gestapelte Halbleiterkörper eine Vielzahl von Mesabereichen (M1, M2, M3) aufweist, die jeweils eine Vielzahl der lichtemittierenden Bereiche einschließen.

5. Lichtemittierende Vorrichtung nach Anspruch 1, wobei es eine Vielzahl von ersten elektrisch leitfähigen Schichten gibt, die die erste elektrisch leitfähige Schicht einschließen; und eine Anzahl der Vielzahl von ersten elektrisch leitfähigen Schichten kleiner als eine Anzahl der Elektroden ist.

6. Lichtemittierende Vorrichtung nach einem der Ansprüche 1 bis 5, wobei jeder von einer Vielzahl der lichtemittierenden Bereiche den Laserstrahl von der Substratseite emittiert.

7. Lichtemittierende Vorrichtung nach Anspruch 6, wobei die zweite elektrisch leitfähige Schicht eine Vielzahl von Öffnungen aufweist, die in Verbindung mit einer Vielzahl der lichtemittierenden Bereiche bereitgestellt ist, wobei die Vielzahl von Öffnungen jeweils den Laserstrahl führen.

8. Lichtemittierende Vorrichtung nach Anspruch 6, wobei die zweite elektrisch leitfähige Schicht eine elektrisch leitfähige Schicht einschließt, die eine Transparenz für den Laserstrahl aufweist.

9. Lichtemittierende Vorrichtung nach einem der Ansprüche 1 bis 8, wobei die lichtemittierende Vorrichtung ein Flip-Chip ist, der auf einem Montagesubstrat von einer Seite montiert ist, auf der die erste elektrisch leitfähige Schicht bereitgestellt ist.

10. Lichtemittierende Einrichtung, umfassend
eine lichtemittierende Vorrichtung nach Anspruch 1, die ein Flip-Chip ist, der auf einem Montagesubstrat montiert ist.

## Revendications

1. Dispositif électroluminescent (1) comprenant :
un substrat (10) ayant une première surface (10A) et une seconde surface qui sont opposées l'une à l'autre ;
un corps empilé semi-conducteur (ST) qui est fourni sur la première surface du substrat, le corps empilé semi-conducteur ayant une pluralité de régions électroluminescentes (L1, L2, L3) dont chacune permet d'émettre un faisceau laser ;
une première couche électriquement conductrice (23) qui est fournie sur une surface avant du corps empilé semi-conducteur, la surface avant étant opposée au substrat ;
une seconde couche électriquement conductrice (24) qui est fournie sur la seconde surface du substrat, la seconde couche électriquement conductrice étant fournie pour permettre à une tension prédéterminée d'être appliquée au corps empilé semi-conducteur dans chacune d'une pluralité de régions électroluminescentes ;
une ligne de câblage traversante (19) qui couple électriquement la première couche électriquement conductrice et la seconde couche électriquement conductrice ; et
une pluralité d'électrodes (21) qui sont fournies sur la surface avant du corps empilé semi-conducteur, la surface avant étant opposée au substrat, la pluralité d'électrodes étant fournies pour permettre à des tensions prédéterminées d'être appliquées au corps empilé semi-conducteur dans une pluralité des régions électroluminescentes respectives.

2. Dispositif électroluminescent selon la revendication 1, dans lequel le corps empilé semi-conducteur a une première couche réfléchissant la lumière (12), une couche active (13) et une seconde couche réfléchissant la lumière (14) empilées dans l'ordre depuis le côté substrat.

3. Dispositif électroluminescent selon la revendication 2, dans lequel le corps empilé semi-conducteur comporte en outre une couche de confinement de courant (16) entre la couche active et la seconde couche réfléchissant la lumière, la couche de confinement de courant ayant une région d'injection de courant (16A).

4. Dispositif électroluminescent selon l'une quelconque des revendications 1 à 3, dans lequel le corps empilé semi-conducteur a une pluralité de régions mesa (M1, M2, M3) comportant chacune une pluralité des régions électroluminescentes.

5. Dispositif électroluminescent selon la revendication 1, dans lequel il y a une pluralité de premières couches électriquement conductrices comportant la première couche électriquement conductrice ; et un nombre de la pluralité de premières couches électriquement conductrices est plus petit qu'un nombre des électrodes.

6. Dispositif électroluminescent selon l'une quelconque des revendications 1 à 5, dans lequel chacune d'une pluralité des régions électroluminescentes émet le faisceau laser depuis le côté substrat.

7. Dispositif électroluminescent selon la revendication 6, dans lequel la seconde couche électriquement conductrice a une pluralité d'ouvertures qui sont fournies en association avec une pluralité des régions électroluminescentes, la pluralité des ouvertures guidant chacune le faisceau laser.

8. Dispositif électroluminescent selon la revendication 6, dans lequel la seconde couche électriquement conductrice comporte une couche électriquement conductrice qui a une transparence au faisceau laser.

9. Dispositif électroluminescent selon l'une quelconque des revendications 1 à 8, dans lequel le dispositif électroluminescent est monté en puce retournée sur un substrat de montage à partir d'un côté sur lequel la première couche électriquement conductrice est fournie.

10. Appareil électroluminescent comprenant
un dispositif électroluminescent selon la revendication 1 qui est monté en puce retournée sur un substrat de montage.
